# EUROPÄISCHE PATENTANMELDUNG

(11) **EP 3 255 387 A1**
(43) Veröffentlichungstag der Anmeldung: **13.12.2017**
(21) Anmeldenummer: 17171698.8
(22) Anmeldetag: 18.05.2017
(51) Int. Cl.: G01D 11/24, G01D 11/30, H05K 3/36

(54) **SENSORGEHÄUSE**

(30) Priorität: 07.06.2016 DE 102016110466
(71) Anmelder: Sick AG, 79183 Waldkirch (DE)
(72) Erfinder: Yltchev-Edelmann, Georgy, 79194 Gundelfingen (DE)

(57) **Zusammenfassung**

Sensorgehäuse mit einem Sensorelement (2), wobei das Sensorgehäuse (1) einen elektrischen Anschluss (3) mit einem Kabel (4) mit mindestens zwei Leitungen (5) und eine erste Leiterplatte (6) aufweist, wobei die Leitungen (5) in einem Kontaktadapter (7) kontaktiert angeordnet sind, wobei der Kontaktadapter (7) eine zweite Leiterplatte (8) ist und metallische Kontaktflächen (9) aufweist, wobei die Kontaktflächen (9) jeweils in unterschiedlichen Flächenabschnitten (22) angeordnet sind, wobei ein erster Flächenabschnitt (23) mit der Leitung verbunden ist und die zweiten Flächenabschnitte (24) der jeweiligen Kontaktflächen (9) eine gemeinsame plane Ebene (11) aufweisen, wobei diese plane Ebene (11) mit mindestens einem ersten Ende (12) mindestens eines elastischen Kontaktmittels (14) verbunden ist und ein zweites Ende (13) des elastischen Kontaktmittels (14) mit der ersten Leiterplatte (6) verbunden ist.

## Beschreibung

Die vorliegende Erfindung betrifft ein Sensorgehäuse nach dem Oberbegriff von Anspruch 1.

Sensorgehäuse werden nach dem Stand der Technik mit einem Anschlusskabel mit Leitungen verbunden. Dabei wird beispielsweise eine elektronische Baugruppe des Sensors mit dem Kabel bzw. den Leitungen verlötet und dann anschließend in dem Sensorgehäuse angeordnet, wobei das Kabel durch eine Kabelöffnung gefädelt wird. Danach werden weitere Baugruppen in dem Sensorgehäuse angeordnet. Diese Lösungen erfordern eine Montage des Anschlusses bevor die Baugruppen des Sensors montiert werden.

Weiter ist es beispielsweise nach dem Stand der Technik vorgesehen, dass Anschlüsse an dem Sensorgehäuse von außen auf das Sensorgehäuse aufgesteckt werden und dann beispielsweise mit dem Sensorgehäuse verklebt werden. Diese Lösungen führen zu einer unnötigen Vergrößerung der Außenabmessungen des Sensors.

Eine Aufgabe der Erfindung besteht darin, einen Sensor bereitzustellen, wobei der Anschluss am Ende der Fertigung des Sensors erfolgen kann, wobei der Anschluss möglichst wenig Platz beanspruchen soll. Weiter sollen die Toleranzanforderungen niedrig sein. Weiter soll eine kostengünstige Anschlussmöglichkeit für Sensoren bereitgestellt werden.

Die Aufgabe wird gemäß Anspruch 1 gelöst durch ein Sensorgehäuse mit einem Sensorelement, wobei das Sensorgehäuse einen elektrischen Anschluss mit einem Kabel mit mindestens zwei Leitungen und eine erste Leiterplatte aufweist, wobei die Leitungen in einem Kontaktadapter kontaktiert angeordnet sind, wobei der Kontaktadapter eine zweite Leiterplatte ist und metallische Kontaktflächen aufweist, wobei die Kontaktflächen jeweils in unterschiedlichen Flächenabschnitten angeordnet sind, wobei ein erster Flächenabschnitt mit der Leitung verbunden ist und die zweiten Flächenabschnitte der jeweiligen Kontaktflächen eine gemeinsame plane Ebene aufweisen, wobei der zweite Flächenabschnitt rechtwinklig zu dem ersten Flächenabschnitt ist, wobei diese plane Ebene mit mindestens einem ersten Ende mindestens eines elastischen Kontaktmittel verbunden ist und ein zweites Ende des elastischen Kontaktmittels mit der ersten Leiterplatte verbunden ist.

Gemäß der Erfindung wird ein Kontakt zwischen dem Kontaktadapter und der ersten Leiterplatte nur über einen Berührungskontakt des elastischen Kontaktmittels gebildet. Die Kontaktierung erfolgt dabei lediglich durch die Einführungsbewegung entlang einer Längsachse der Öffnung des Sensorgehäuses. Die Kontaktierung erfolgt damit an einem bereits komplett montierten Sensor mit geschlossenem Sensorgehäuse. Lediglich die Öffnung für den Kontaktadapter ist noch offen.

Durch das elastische Kontaktmittel ist die Kontaktierung toleranzunempfindlich. Auch bei Temperaturschwankungen wird eine sichere Kontaktierung gewährleistet. Weiter ist die Kontaktierung platzsparend ausgeführt, da die notwendigen Komponenten zum Anschluss in der Öffnung des Sensorgehäuses platziert werden können.

Weiter kann gemäß der Erfindung der elektrische Anschluss des Sensorgehäuses montiert werden, nachdem alle Komponenten, einschließlich einer Frontscheibe in dem Sensorgehäuse montiert sind. Die Anordnung des elektrischen Anschlusses ist quasi der letzte Arbeitsschritt bei der Montage des Sensors.

Gemäß der Erfindung kann das Kabel mit dem Kontaktadapter durch eine Öffnung des Sensorgehäuses von außen eingeführt werden. Das Kabel kann dabei optional mit einer Kunststoffmasse umspritzt sein. Diese Kunststoffmasse bildet einen Kunststoffkörper, der an die Form der Öffnung des Gehäuses angepasst ist. Auf dieser Kunststoffmasse kann optional ein Dichtungsring angeordnet sein, um eine dichte Verbindung zwischen dem Kunststoffkörper und dem Sensorgehäuse zu bilden.

Nach dem Einführen des Kontaktadapters mit dem Kabel wird die plane Ebene des Kontaktadapters mit mindestens dem ersten Ende des elastischen Kontaktmittels verbunden. Das elastische Kontaktmittel ist bereits im Sensorgehäuseinnern angeordnet und mit der ersten Leiterplatte verbunden.

Nach Einführen des Kontaktadapters mit dem Kabel und dem Kunststoffkörper wird der Kunststoffkörper in der Öffnung des Sensorgehäuses fixiert. Dazu ist beispielsweise in der Öffnung des Sensorgehäuses und in dem Kunststoffkörper jeweils ein Hinterschnitt bzw. jeweils eine Aussparung vorgesehen, wobei sich die Hinterschnitte bzw. die Aussparungen gegenüberstehen. Die Hinterschnitte bzw. die Aussparung werden beispielsweise mit einer Arretierfeder fixiert, oder mit einer Vergussmasse gefüllt, um den Kunststoffkörper in der Öffnung des Sensorgehäuses zu befestigen.

In Weiterbildung ist das elastische Kontaktmittel ein elastischer Kontaktkörper und die plane Ebene liegt auf einer ersten Ebene des elastischen Kontaktkörpers auf und eine zweite Ebene des elastischen Kontaktkörpers liegt auf der ersten Leiterplatte auf.

Der elastische Kontaktkörper besteht dabei aus elastischem leitfähigen Material pro Kontaktabschnitt. Zwischen diesem leitfähigen Material sind elastische Isolierkörper angeordnet, um die einzelnen Kontaktabschnitte zu trennen. Durch den elastischen Kontaktkörper ist eine Kontaktierung auch bei Maßtoleranzen der mechanischen Komponenten gewährleistet.

In einer bevorzugten Ausführungsform der Erfindung weist der elastische Kontaktkörper einen elastischen Isolierkörper auf und eine Vielzahl jeweils isolierter Leiter auf, deren Enden jeweils an der ersten Ebene und an der zweiten Ebene kontaktierbar sind. Die Leiter sind beispielsweise durch eine Vielzahl nebeneinander angeordneter Spiralfedern, Leiterbüschel oder Kontaktfedern gebildet, die von einem elastischen Isolierkörper umgeben sind. Anders formuliert sind eine Vielzahl von parallel beabstandeten flexiblen Leitern in einem elastischen Isolierkörper angeordnet. Dadurch wird quasi eine Leitermatte gebildet, die unabhängig von der Ausrichtung leitende Verbindungen zwischen der planen Ebene des Kontaktadapters und der ersten Leiterplatte bildet.

Der elastische Kontaktkörper kann auch als Leitermatte bezeichnet werden. Der elastische Kontaktkörper kann beispielsweise auch nur aus Kunststoff/Elastomer bestehen, entscheidend ist die unidirektionale Leitfähigkeit nur in Richtung senkrecht zur Leiterplatten-Ebene.

In einer weiteren Ausführung kann der Kontaktadapter durch einen anisotrop leitfähigen Klebstoff angeschlossen werden. Die Leitfähigkeit in die gewünschte Richtung entsteht durch eine Anpressung der zu klebenden Bauteile in diese Richtung.

In Weiterbildung der Erfindung ist das elastische Kontaktmittel durch federnde Kontaktelemente gebildet. Die federnden Kontaktelemente sind beispielsweise durch Spiralfedern oder ähnliche Federelemente gebildet. Die federnden Kontaktelemente sind zur Isolierung beispielsweise lediglich beabstandet angeordnet, ohne zusätzliche Isolierungsmittel.

In Weiterbildung der Erfindung sind die federnden Kontaktelemente auf dem Kontaktadapter und/oder auf der Leiterplatte angeordnet. Die federnden Kontaktelemente können dabei beispielsweise direkt auf den Kontaktflächen der planen Ebene angeordnet werden. Beispielsweise sind die federnden Kontaktelemente einstückig oder per Lötung mit den Kontaktflächen verbunden. Die federnden Kontaktelemente werden dann zusammen mit dem Kontaktadapter in die Öffnung eingeführt und die federnden Kontaktelemente werden gegen die Kontakte der ersten Leiterplatte gedrückt, wodurch ebenfalls eine robuste toleranzunempfindliche Kontaktierung gebildet wird.

Es ist jedoch auch vorgesehen, dass die Kontaktelemente beispielsweise per SMD-Technik auf der Leiterplatte bestückt werden. Dadurch können sie kostengünstig in einem Arbeitsschritt bei der SMD-Bestückung der Leiterplatte positioniert werden und sind bei der Montage besser geschützt.

In Weiterbildung der Erfindung ist der Kontaktadapter automatisiert mit den Leitungen des Kabels verlötbar. Dabei wird der Kontaktadapter in einer Bestückungsmaschine mit den Leitungen verbunden, wobei die Leitungen in den Kontaktadapter gesteckt werden oder der Kontaktadapter auf vorpositionierte Leitungen aufgesteckt wird. Anschließend wird der Kontaktadapter automatisiert mit den Leitungen verlötet, beispielsweise durch Reflow-Lötung. Dadurch ist eine kostengünstige Herstellung möglich.

Optional kann auch der Kontaktadapter mit der verbundenen Leitung automatisiert in die Öffnung des Sensorgehäuses eingeführt werden und befestigt werden. Hierzu ist beispielsweise eine Montagemaschine vorgesehen. Dabei werden die Kontaktadapter und die Sensorgehäuse gegenüberliegend positioniert und anschließend lediglich der Kontaktadapter mit dem Kabel in die Öffnung in einer linearen Bewegung in das Sensorgehäuse eingeschoben und anschließend fixiert. Dadurch kann quasi der gesamte Sensor automatisiert hergestellt werden, ohne dass manuelle Montageschritte notwendig sind. Lediglich das Bereitstellen der Ausgangskomponenten an der Maschine kann beispielsweise manuell erfolgen.

In Weiterbildung der Erfindung ist ein Sensor ein optoelektronischer Sensor. Bei dem optoelektronischen Sensor kann es sich beispielsweise um eine Lichtschranke, einen Lichttaster, einen Distanzsensor, eine Reflexionslichtschranke, ein Lichtgitter oder ähnliches handeln. Derartige Sensoren weisen mindestens ein Sendeelement und mindestens ein Empfangselement auf. Die empfangenen Signale des Empfangselements werden von eine Auswerteeinheit ausgewertet und daraufhin wird ein Objektfeststellungssignal ausgegeben. Das Objektfeststellungssignal wird beispielsweise über die Leitungen einer externen Steuerung zugeführt.

Jedoch kann es sich bei dem Sensor auch um einen induktiven, magnetischen oder kapazitiven Sensor handeln. Weiter kann der Sensor auch ein Ultraschallsensor sein.

Die Erfindung wird nachstehend auch hinsichtlich weiterer Vorteile und Merkmale unter Bezugnahme auf die beigefügte Zeichnung anhand von Ausführungsbeispielen erläutert. Die Figuren der Zeichnung zeigen in:
- Figur 1: ein Sensorgehäuse mit einem elektrischen Anschluss;
- Figur 1a: ein Sensorgehäuse mit einem elektrischen Anschluss;
- Figur 2: einen Kontaktadapter mit einem Kabel und Leitungen;
- Figur 3: einen Kontaktadapter mit einem elastischen Kontaktkörper und einer Leiterplatte;
- Figur 4: einen Kontaktadapter mit einem elastischen Isolierkörper und Leitern;
- Figur 5: einen Kontaktadapter mit federnden Kontaktelementen.

In den nachfolgenden Figuren sind identische Teile mit identischen Bezugszeichen versehen.

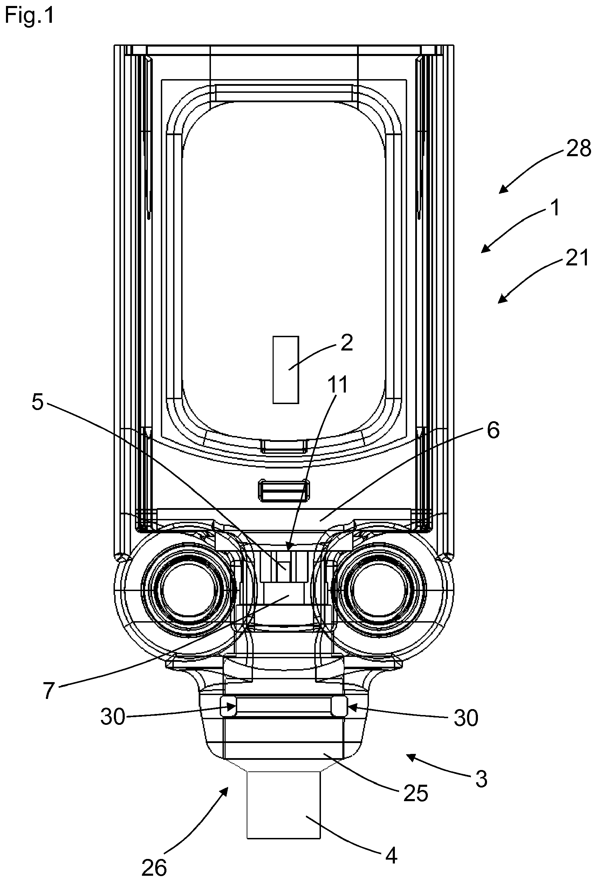

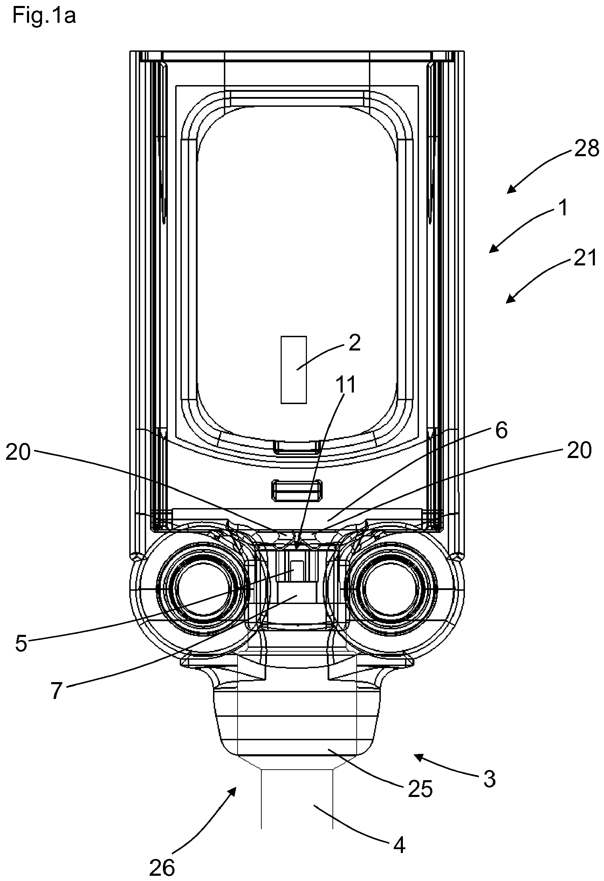

Figur 1 zeigt ein Sensorgehäuse 1 mit einem Sensorelement 2, wobei das Sensorgehäuse 1 einen elektrischen Anschluss 3 mit einem Kabel 4 mit mindestens zwei Leitungen 5 und eine erste Leiterplatte 6 aufweist. Das Sensorgehäuse ist gemäß Figur 1 transparent dargestellt. Gemäß Figur 1 ist der Sensor 28 beispielsweise ein optoelektronischer Sensor 21.

Figur 1a zeigt ein weiteres Sensorgehäuse 1 mit einem Sensorelement 2, wobei das Sensorgehäuse 1 einen elektrischen Anschluss 3 mit einem Kabel 4 mit mindestens zwei Leitungen 5 und eine erste Leiterplatte 6 aufweist. Gemäß Figur 1a sind federnde Kontaktelemente 20 zwischen dem Kontaktadapter 7 und der ersten Leiterplatte 6 vorgesehen. Das Sensorgehäuse ist gemäß Figur 1a transparent dargestellt. Gemäß Figur 1a ist der Sensor 28 beispielsweise ein optoelektronischer Sensor 21.

Gemäß Figur 1a ist eine einfache Hotmeltanbindung zwischen Sensorgehäuse 1 und Kabel 4 angelegt. Dadurch entfällt eine Vorumspritzung. Dadurch ist auch kein O-Ring und keine Arretierfeder erforderlich.

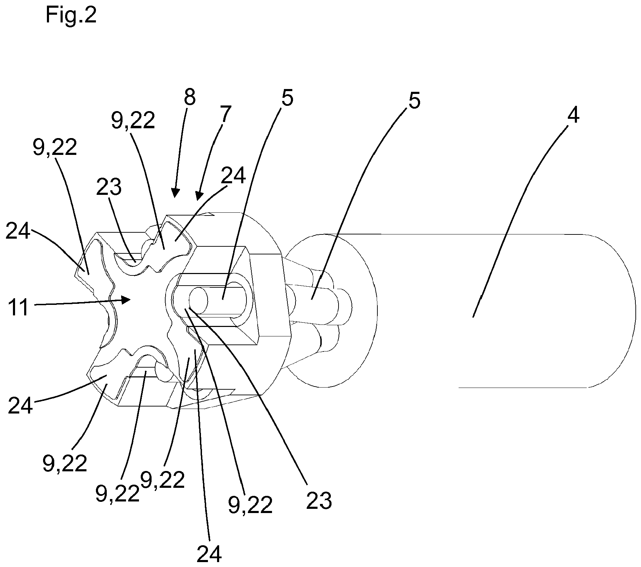

Gemäß Figur 2 sind die Leitungen 5 in einem Kontaktadapter 7 kontaktiert angeordnet. Der Kontaktadapter 7 ist eine zweite Leiterplatte 8 und weist metallische Kontaktflächen 9 auf. Die Kontaktflächen 9 sind jeweils in unterschiedlichen Flächenabschnitten 22 angeordnet, wobei ein erster Flächenabschnitt 23 mit der Leitung 5 verbunden ist und die zweiten Flächenabschnitte 24 der jeweiligen Kontaktflächen 9 eine gemeinsame plane Ebene 11 aufweisen.

Gemäß Figur 2 sind die abisolierten bzw. nicht isolierten Enden der Leitungen 5 dabei durch Löcher oder Öffnungen des Kontaktadapters 7 hindurchgesteckt und liegen an jeweils dem ersten Flächenabschnitt 23 an. Dieser erste Flächenabschnitt 23 ist an die Form des abisolierten Leiterendes angepasst und weist eine etwa halbrunde Form mit einem Lötauge auf. Der erste Flächenabschnitt 23 ist mit dem zweiten Flächenabschnitt 24 elektrisch verbunden. Der zweite Flächenabschnitt befindet sich rechtwinklig zu dem ersten Flächenabschnitt. Die Leiterenden liegen in kammerartigen Abschnitten des Kontaktadapters. Die Flächenabschnitte 22 sind beispielsweise aus Kupferlegierungen hergestellt und werden in einem Ätzverfahren hergestellt. Der Grundkörper des Kontaktadapters besteht beispielsweise aus einem Duroplast.

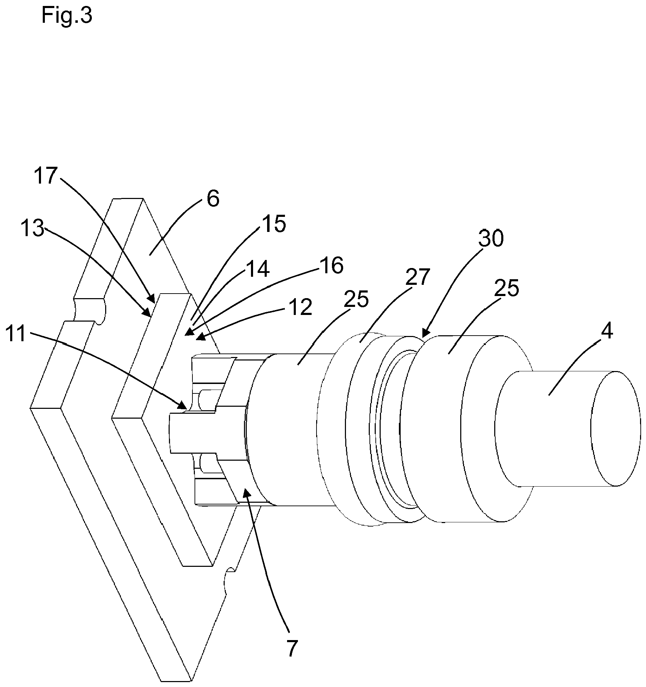

Gemäß Figur 3 und Figur 1 ist diese plane Ebene 11 mit mindestens einem ersten Ende 12 mit mindestens einem elastischen Kontaktmittel 14 verbunden und ein zweites Ende 13 des elastischen Kontaktmittels 14 ist mit der ersten Leiterplatte 6 verbunden.

Gemäß Figur 2 ist der Kontaktadapter 7 automatisiert mit den Leitungen 5 des Kabels 4 verlötet. Dabei wird der Kontaktadapter 7 in einer Bestückungsmaschine mit den Leitungen 5 verbunden, wobei die Leitung 5 in den Kontaktadapter 7 gesteckt wird oder der Kontaktadapter 7 auf vorpositionierte Leitungen 5 aufgesteckt wird. Anschließend wird der Kontaktadapter 7 automatisiert mit den Leitungen 5 verlötet, beispielsweise durch eine Reflow-Lötung.

Gemäß Figur 3 wird ein Kontakt zwischen dem Kontaktadapter 7 und der ersten Leiterplatte 6 nur über einen Berührungskontakt des elastischen Kontaktmittels 14 gebildet. Die Kontaktierung erfolgt dabei lediglich durch die Einführungsbewegung entlang einer Längsachse der Öffnung 29 des Sensorgehäuses 1 gemäß Figur 1.

Die notwendigen Komponenten zum Anschluss sind in der Öffnung 26 des Sensorgehäuses 1 platziert.

Gemäß Figur 1 wird der elektrische Anschluss 3 des Sensorgehäuses 1 montiert, nachdem alle Komponenten, einschließlich einer Frontscheibe, in dem Sensorgehäuse 1 montiert sind. Die Anordnung des elektrischen Anschlusses 3 ist quasi der letzte Arbeitsschritt bei der Montage des Sensors 28.

Gemäß Figur 1 wird das Kabel 4 mit dem Kontaktadapter 7 durch die Öffnung 26 des Sensorgehäuses 1 von außen eingeführt. Das Kabel 4 ist dabei gemäß Figur 3 mit einer Kunststoffmasse umspritzt. Diese Kunststoffmasse bildet einen Kunststoffkörper 25, der an die Form der Öffnung 26 des Sensorgehäuses 1 angepasst ist. Auf dieser Kunststoffmasse ist ein Dichtungsring 27 angeordnet, um eine dichte Verbindung zwischen dem Kunststoffkörper 25 und dem Sensorgehäuse 1 zu bilden.

Nach dem Einführen des Kontaktadapters 7 mit dem Kabel 4 wird die plane Ebene 11 des Kontaktadapters 7 mit mindestens dem ersten Ende 16 des elastischen Kontaktmittels 14 verbunden, wie in Figur 3 dargestellt. Das elastische Kontaktmittel 14 ist bereits im Sensorgehäuseinnern angeordnet und mit der ersten Leiterplatte 6 verbunden. Das Sensorgehäuse ist in Figur 3 zur besseren Darstellung des elektrischen Anschlusses nicht dargestellt.

Nach Einführen des Kontaktadapters gemäß Figur 1 mit dem Kabel 4 und dem Kunststoffkörper 25, wird der Kunststoffkörper 25 in der Öffnung 26 des Sensorgehäuses 1 fixiert. Dazu ist beispielsweise in der Öffnung 26 des Sensorgehäuses 1 und in dem Kunststoffkörper 25 jeweils ein Hinterschnitt bzw. jeweils eine Aussparung 30 vorgesehen, wobei sich die Hinterschnitte bzw. die Aussparungen 30 gegenüberstehen. Die Hinterschnitte bzw. die Aussparung 30 wird mit einer Vergussmasse gefüllt, um den Kunststoffkörper 25 in der Öffnung des Sensorgehäuses 1 zu befestigen.

Gemäß Figur 3 ist das elastische Kontaktmittel 14 ein elastischer Kontaktkörper 15 und die plane Ebene 11 liegt auf einer ersten Ebene 16 des elastischen Kontaktkörpers 15 auf und eine zweite Ebene 17 des elastischen Kontaktkörpers 15 liegt auf der ersten Leiterplatte 6 auf.

Der elastische Kontaktkörper 15 besteht dabei aus elastischem leitfähigen Material pro Kontaktabschnitt. Zwischen diesem leitfähigen Material sind elastische Isolierkörper angeordnet, um die einzelnen Kontaktabschnitte zu trennen. Durch den elastischen Kontaktkörper 15 ist eine Kontaktierung auch bei Maßtoleranzen der mechanischen Komponenten gewährleistet.

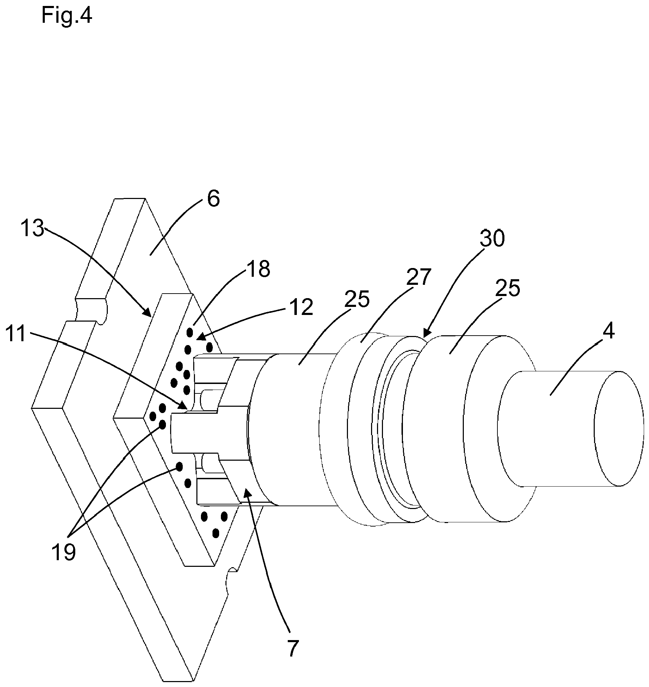

Gemäß Figur 4 weist der elastische Kontaktkörper einen elastischen Isolierkörper 18 und eine Vielzahl jeweils isolierter Leiter 19 auf, deren Enden jeweils an der ersten Ebene und an der zweiten Ebene kontaktierbar sind. Die Leiter 19 sind beispielsweise durch eine Vielzahl nebeneinander angeordneter Spiralfedern, Leiterbüschel oder Kontaktfedern gebildet die von einem elastischen Isolierkörper 18 umgeben sind.

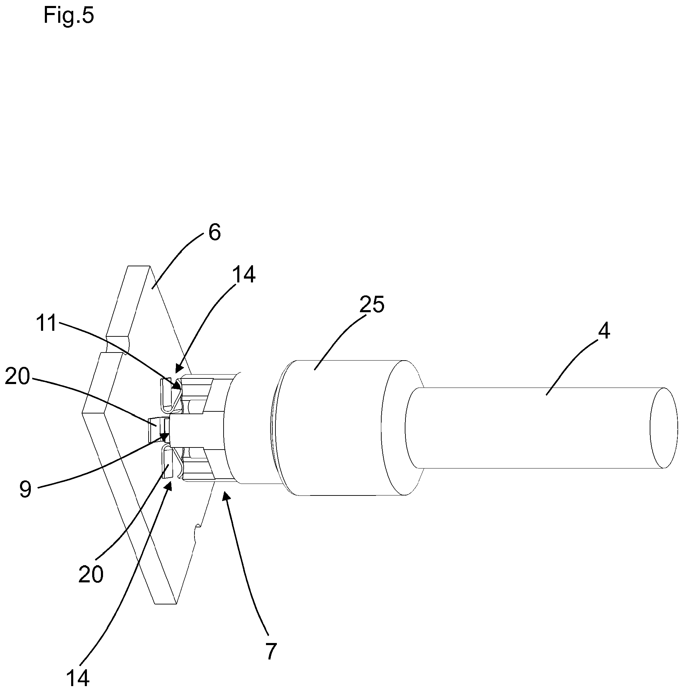

Gemäß Figur 5 ist das elastische Kontaktmittel 14 durch federnde Kontaktelemente 20 gebildet. Die federnden Kontaktelemente 20 sind beispielsweise durch Spiralfedern oder ähnliche Federelemente gebildet. Die federnden Kontaktelemente 20 sind zur Isolierung beispielsweise lediglich beabstandet angeordnet, ohne zusätzliche Isolierungsmittel.

Gemäß Figur 5 sind die federnden Kontaktelemente 20 gemäß Figur 1 a auf dem Kontaktadapter 7 bzw. auf der ersten Leiterplatte 6 angeordnet. Die federnden Kontaktelemente 20 können dabei beispielsweise direkt auf den Kontaktflächen 9 der planen Ebene 11 angeordnet werden. Beispielsweise sind die federnden Kontaktelemente 20 einstückig oder per Lötung mit den Kontaktflächen 9 verbunden. Die federnden Kontaktelemente 20 werden dann zusammen mit dem Kontaktadapter 7 in die Öffnung 26 gemäß Figur 1 eingeführt und die federnden Kontaktelemente 20 werden gegen die Kontakte der ersten Leiterplatte 6 gedrückt. Der Kunststoffkörper ist durch Einspritzen von Kunststoff, sog. Hotmelt, gebildet, entsprechend zu Figur 1a.

Es ist jedoch auch vorgesehen, dass die Kontaktelemente 20 beispielsweise per SMD-Technik auf der Leiterplatte 6 bestückt werden. Dadurch können sie kostengünstig, in einem Arbeitsschritt bei der SMD-Bestückung der Leiterplatte 6 positioniert werden und sind bei der Montage besser geschützt

### Bezugszeichen:

- 1: Sensorgehäuse
- 2: Sensorelement
- 3: elektrischer Anschluss
- 4: Kabel
- 5: Leitungen
- 6: erste Leiterplatte
- 7: Kontaktadapter
- 8: zweite Leiterplatte
- 9: Kontaktflächen
- 11: plane Ebene
- 12: erstes Ende
- 13: zweites Ende
- 14: elastisches Kontaktmittel
- 15: elastischer Kontaktkörper
- 16: erste Ebene
- 17: zweite Ebene
- 18: elastischer Isolierkörper
- 19: isolierter Leiter
- 20: federnde Kontaktelemente
- 21: optoelektronischer Sensor
- 22: Flächenabschnitte
- 23: erster Flächenabschnitt
- 24: zweiter Flächenabschnitt
- 25: Kunststoffkörper
- 26: Öffnung
- 27: Dichtungsring
- 28: Sensor
- 30: Aussparung

## Patentansprüche

1. Sensorgehäuse mit einem Sensorelement (2), wobei das Sensorgehäuse (1) einen elektrischen Anschluss (3) mit einem Kabel (4) mit mindestens zwei Leitungen (5) und eine erste Leiterplatte (6) aufweist,
**dadurch gekennzeichnet, dass**
die Leitungen (5) in einem Kontaktadapter (7) kontaktiert angeordnet sind, wobei der Kontaktadapter (7) eine zweite Leiterplatte (8) ist und metallische Kontaktflächen (9) aufweist,
wobei die Kontaktflächen (9) jeweils in unterschiedlichen Flächenabschnitten (22) angeordnet sind,
wobei ein erster Flächenabschnitt (23) mit der Leitung verbunden ist und die zweiten Flächenabschnitte (24) der jeweiligen Kontaktflächen (9) eine gemeinsame plane Ebene (11) aufweisen,
wobei der zweite Flächenabschnitt rechtwinklig zu dem ersten Flächenabschnitt ist,
wobei diese plane Ebene (11) mit mindestens einem ersten Ende (12) mindestens eines elastischen Kontaktmittels (14) verbunden ist und ein zweites Ende (13) des elastischen Kontaktmittels (14) mit der ersten Leiterplatte (6) verbunden ist.

2. Sensorgehäuse nach Anspruch 1, **dadurch gekennzeichnet, dass** das elastische Kontaktmittel (14) ein elastischer Kontaktkörper (15) ist und die plane Ebene (11) auf einer ersten Ebene (16) des elastischen Kontaktkörpers (15) aufliegt und eine zweite Ebene (17) des elastischen Kontaktkörpers (15) auf der ersten Leiterplatte (6) aufliegt.

3. Sensorgehäuse nach Anspruch 2, **dadurch gekennzeichnet, dass** der elastische Kontaktkörper (15) einen elastischen Isolierkörper (18) aufweist und eine Vielzahl jeweils isolierter Leiter (19) aufweist, deren Enden jeweils an der ersten Ebene (16) und an der zweiten Ebene (17) kontaktierbar sind.

4. Sensorgehäuse nach Anspruch 1, **dadurch gekennzeichnet, dass** das elastische Kontaktmittel (14) durch federnde Kontaktelemente (20) gebildet ist.

5. Sensorgehäuse nach Anspruch 4, **dadurch gekennzeichnet, dass** die federnden Kontaktelemente (20) auf dem Kontaktadapter (7) und/oder auf der Leiterplatte (6) angeordnet sind.

6. Sensorgehäuse nach mindestens einem der vorhergehenden Ansprüche, **dadurch gekennzeichnet, dass** der Kontaktadapter (7) automatisiert mit den Leitungen (5) des Kabels (4) verlötbar ist.

7. Sensorgehäuse nach mindestens einem der vorhergehenden Ansprüche, **dadurch gekennzeichnet, dass** ein Sensor (28) ein optoelektronischer Sensor (21) ist.
